# EUROPÄISCHE PATENTANMELDUNG

(11) **EP 1 610 597 A1**
(43) Veröffentlichungstag der Anmeldung: **28.12.2005**
(21) Anmeldenummer: 04014556.7
(22) Anmeldetag: 22.06.2004
(51) Int. Cl.: H05K 3/18, C23C 18/14

(54) **Ausscheiden von Kupfer zur Erzeugung von Leiterbahnen**

(71) Anmelder: Technomedica AG, 8852 Wollerau (CH)
(72) Erfinder: Linder, Patrick, 5318 Mandach (CH)
(74) Vertreter: Troesch Scheidegger Werner AG

(57) **Zusammenfassung**

Für das Ausscheiden von Kupfer aus einer Kupfer-II-Salzlösung (2), wie insbesondere einer Kupfersulfatlösung für die Herstellung von Schaltkreisen bzw. Schaltungen auf Leiterplatten, Mikroprozessoren, Chips und dgl. wird vorgeschlagen, die Kupfer-II-Salzlösung gezielt mittels grünem Licht zu belichten. Die Lösung (2) wird dabei mittels eines Lichtstrahles (3), wie insbesondere mittels eines Lasers belichtet, aufweisend dieselbe Wellenlänge, welche der Farbe der Kupfer-II-Salzlösung entspricht, wie insbesondere der Kupfer-II-Sulfatlösung bzw. Kupfervitriol.

## Beschreibung

Die vorliegende Erfindung betrifft ein Verfahren zum Ausscheiden von Kupfer aus einer Kupfer-II-Salzlösung, wie insbesondere einer Kupfersulfatlösung, ein Verfahren zum Erzeugen von Leiterbahnen bzw. Leiterstrukturen, sowie ggf. zum Dotieren von Piezokristallen auf Leiterplatten, Chips und dergleichen, sowie mittels dem Verfahren hergestellte Leiterplatten, Schaltungen, Mikroprozessoren, Chips und dergleichen.

Die wohl bekannteste Methode zum Erzeugen von Leiterbahnen ist die sogenannte Subtraktionstechnik bzw. Lithographietechnik, indem für Leiterplatten verwendete Basismaterialien mit beispielsweise Kupferfolien beschichtet werden und anschliessend mittels sogenannten Photolacken und ggf. wiederholter Oberflächenbehandlung mittels Ätzen die gewünschte Struktur hergestellt wird. Diese Verfahren sind an sich bestens bekannt und auf eine Darstellung derselben kann verzichtet werden.

Für diese Lithographietechnik sind aber eine Vielzahl von Prozessschritten notwendig, womit das Verfahren, wenn auch weitgehendst automatisiert, aufwendig und relativ teuer ist. Auch werden durch immer kleinere Chips bzw. Mikroprozessoren die Anforderungen an die Präzision dieses Verfahrens erhöht. So wird beispielsweise für das Belichten von Photolacken neuerdings extrem kurzwelliges Licht vorgeschlagen, um Leiterbahnen im Nanobereich zu ermöglichen.

Weiter werden Leiterbahnen auch durch direktes elektrochemisches Ausscheiden von beispielsweise Kupfer aus einer Kupfersulfatelektrolytlösung erzeugt.

Die Aufgabe der vorliegenden Erfindung besteht im Bereitstellen eines einfachen, kostengünstigen und genauen Verfahrens für das Erzeugen u.a. von Leiterbahnen bzw. Leiterstrukturen für die Herstellung beispielsweise von Leiterplatten, Chips, Schaltungen, Mikroprozessoren und dergleichen.

Erfindungsgemäss wird einerseits ein Verfahren zum Ausscheiden von Kupfer aus einer Kupfer-(II)-Salzlösung, wie insbesondere einer Kupfersulfatlösung vorgeschlagen sowie weiter ein Verfahren zum Erzeugen von Leiterbahnen bzw. einer Leiterstruktur gemäss dem Wortlaut nach Anspruch 1 resp. nach Anspruch 4.

Überraschenderweise hat es sich gezeigt, dass Kupfer aus einer Kupfer-II-Salzlösung, wie insbesondere einer Kupfer-II-Sulfatlösung ausgeschieden wird bei Belichten mittels grünem Laserlicht, wobei die Wellenlänge des für die Belichtung verwendeten Lichts derjenigen der Farbe entspricht, welche beispielsweise für Kupfervitriol bzw. Kupfer-II-Sulfat typisch ist.

Entsprechend wird vorgeschlagen, ein Substrat vorgesehen für die Herstellung einer Leiterplatte, eines Chips, einer Schaltung oder eines Mikroprozessors mit einer Lösung, enthaltend eine wässrige Kupfer-II-Salzlösung, wie Kupfer-II-Sulfat zu überdecken und strukturiert mit Licht bzw. mit einem grünen Lichtstrahl zu belichten, worauf auf dem Substrat Kupfer abgeschieden wird bzw. die genau strukturierten Leiterbahnen erzeugt werden.

Für die Herstellung der Kupfer-II-Sulfatlösung, wie insbesondere der Kupfervitriol enthaltenden Lösung, wird zunächst entweder Kupferoxid mit Natriumpersulfat in einer wässrigen Lösung gemischt, wobei eine weitgehendst gesättigte Kupfervitriollösung anzustreben ist. Alternativ kann aber auch von einem bereits mit einer Kupferschicht versehenem Substrat, wie einer sogenannten Printplatte oder Chipsubstratplatte ausgegangen werden, welche mit Natriumpersulfatlösung versetzt wird, derart, dass Kupfer vollständig vom Substrat gelöst wird. Natriumpersulfat wird bekanntlich auch bei dem oben erwähnten Lithographieverfahren zum Ätzen von metallischen Oberflächen verwendet.

Anschliessend wird die so erzeugte Kupfervitriollösung mit einer basischen, wässrigen Lösung, enthaltend einen Photolack, versetzt mit Ätznatron, derart gemischt, dass eine weitgehendst neutrale Lösung entsteht.

Nun wird entsprechend einer Struktur, beispielsweise mit einer Lochmaske, die Lösung mit dem oben erwähnten grünen Laserlicht und/oder grünem polarisiertem Licht belichtet, worauf Kupfer auf dem Substrat abgeschieden wird. Selbstverständlich ist es auch möglich, eine Struktur durch Bewegen eines Laserstrahls zu erzeugen, was allerdings wesentlich mehr Zeit in Anspruch nimmt.

Um möglichst exakte, genau strukturierte Leiterbahnen zu erzeugen, wird sogenanntes Laserlicht bzw. Licht mit parallel verlaufenden Strahlenbündeln verwendet.

Durch weiteres Belichten der Lösung, beispielsweise mittels blauen Lichts, ist es möglich, den Photolack in der Lösung gezielt zu polymerisieren, um so beispielsweise einen Schutzlack zu erzeugen. Beim Photolack handelt es sich um einen handelsüblichen Photolack, wie er auch in der oben erwähnten Lithographietechnik verwendet wird. Bekanntlich bestehen Photolacke aus drei Komponenten wie Bindemittel, Stabilisator und Lösemittel. Beim Bindemittel handelt es sich in der Regel um polymerisierbare Komponenten, wie beispielsweise um einen häufig verwendeten Novolac, bestehend aus einem Copolymer von Phenol und Formaldehyd. Demgegenüber sind Sensibilisatoren Moleküle, die unter Einwirkung von Licht bestimmter Wellenlänge die Löslichkeit des Sensibilisatorsystems und somit des Photolacks verändern. Sensibilisatoren stellen somit die photoaktive Komponente dar, welche die Polymerisation des Bindemittels auslösen. Die im vorliegenden Fall erwähnte Verwendung blauen Lichts eignet sich insbesondere, falls beispielsweise Silbernitrat im Photolack enthalten ist. Selbstverständlich richtet sich die zu verwendende Färbung des Lichts nach dem Sensibilisator und es ist durchaus möglich, auch andere Photolacke und entsprechend andere Lichtfarben für das Aushärten des Photolacks zu verwenden.

Schliesslich hat es sich gezeigt, dass insbesondere bei Verwendung von auf Silizium basierenden Substraten, wie sogenannten Siliziumwafern, in Bereichen, welche überhaupt nicht belichtet werden, sogenannte Piezokristalle ausfällen, womit eine Dotierung auf einem Siliziumwafer erreicht werden kann. Im Falle der Verwendung von Natriumpersulfat entstehen üblicherweise NaSiO₂ Dotierungen auf einem Siliziumwafer.

Schlussendlich wird die Oberfläche gespült, beispielsweise mit einer Lösung mindestens enthaltend 75% Alkohol. Nun ist die Oberfläche versiegelt und gereinigt.

Mit dem erfindungsgemäss definierten Verfahren ist es möglich, Kupferleitbahnen anzufertigen, die sich gar im molekularen Bereich bewegen.

Für das bessere Verständnis wird die Erfindung zusätzlich anhand der beigefügten Figuren beispielsweise näher erläutert.

Dabei zeigen:
Fig. 1 schematisch den Ablauf des erfindungsgemässen Verfahrens; und
Fig. 2 schematisch die Belichtung eines Wafers.

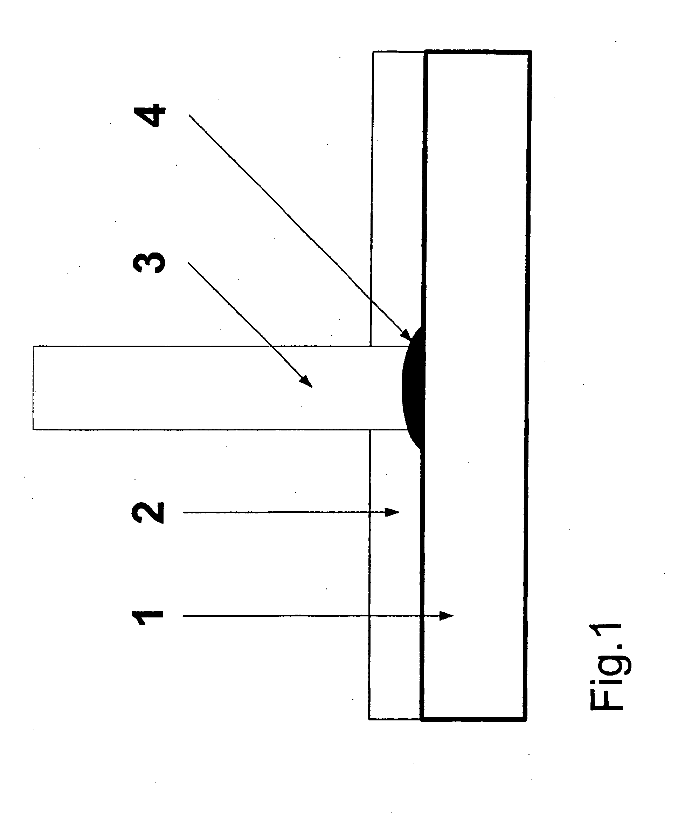

In Figur 1 ist schematisch der Ablauf des erfindungsgemässen Verfahrens dargestellt. Dabei wird mittels eines Laserlichtstrahles 3 eine erfindungsgemäss vorgeschlagene, neutralisierte Lösung 2 belichtet, welche die Kupfer-II-Sulfatlösung, wie insbesondere Kupfervitriollösung, enthält, welche erhalten wird durch Mischen von zunächst Kupferoxid mit Natriumpersulfat und anschliessender Neutralisation mittels einer basischen wässrigen Lösung enthaltend einen Photolack. Die neutralisierte Lösung 2 ist auf einem Wafer oder Trägermaterial 1 angeordnet. Im Bereich wo der Laserlichtstrahl 3 auf die neutralisierte Lösung 2 auftrifft bindet, wie erfindungsgemäss vorgeschlagen, der Kupferausfall 4 statt, zur Erzeugung beispielsweise einer Kupferleitbahn.

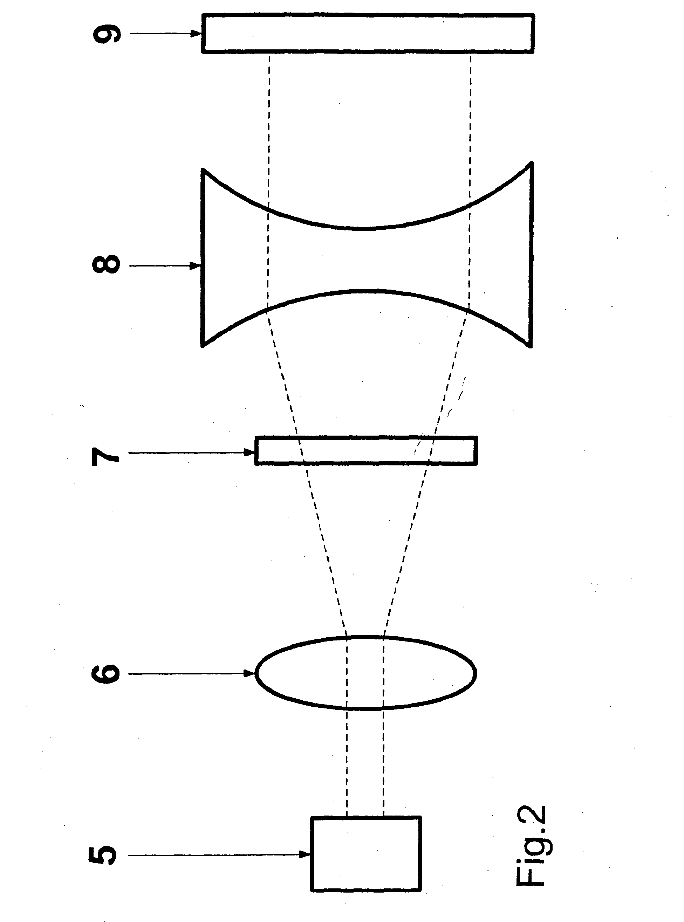

In Figur 2 ist erneut schematisch ein Belichtungsbeispiel dargestellt, wobei Laserlicht von einer Laserquelle 5 emittiert wird. Durch eine Konvexlinse 6 wird der Laserstrahl aufgeweitet und durch eine Maske 7, wie beispielsweise ein Dia oder eine Metallmaske, geführt. In einer nachgeschalteten Konkavlinse 8 wird der aufgeweitete Laserlichtstrahl erneut zu einem parallelen Laserstrahl parallelisiert, und schliesslich auf eine neutralisierte Lösung aufgetragen, um auf einem zu beschichteten Material oder Wafer 9 die gewünschte Kupferleiterbahnstruktur zu erzeugen.

Selbstverständlich handelt es sich bei den in den Figuren 1 und 2 dargestellten Beispielen lediglich um mögliche Ausführungsvarianten und es ist selbstverständlich möglich andere Anordnungen zu verwenden. So ist es beispielsweise in Bezug auf Figur 2 möglich, bereits vor der Maske 3 den Laserstrahl zu parallelen Lichtstrahlen zu bündeln und nachgeschaltet der Maske erneut den Laserlichtstrahl, beispielsweise durch zusätzliche Verwendung einer konvexen Linse, zu einem engen Laserlichtstrahl zusammenzubündeln, um auf einem Kleinstwafer eine erforderliche Kupferleiterbahnstruktur zu erzeugen. Anstelle des oben erwähnten Kupfervitriols ist beispielsweise auch die Verwendung einer wässrigen Kupfer-II-Chloridlösung, bzw. einer Lösung des hydratisierten Kupferchloridsalzes denkbar, wie auch, gegebenenfalls die Verwendung weiterer wässriger Kupfer-II-Salzlösungen, wie beispielsweise Lösungen des Aminsalzes von Kupfer.

Ein Vorteil in Ergänzung zur Einfachheit des oben beschriebenen Verfahrens liegt darin, dass das Erzeugen der Kupferleiterbahnen bei Raumtemperatur durchführbar ist sowie unter Normaldruck. Als vorteilhaft erwiesen hat sich eine relative Luftfeuchtigkeit von ca. 50 bis 70%, vorzugsweise von ca. 55 bis 60%.

Wie bereits eingangs erwähnt, ist das erfindungsgemäss vorgeschlagene Verfahren insbesondere geeignet zum Erzeugen von Leiterplatten, Chips, Mikroprozessoren, Schaltungen aller Art und dergleichen.

Gemäss einem weiteren Aspekt der vorliegenden Erfindung wird vorgeschlagen, für die auf der Leitplatte zu erzeugende Struktur eine Laseroptik zu verwenden, welche die Erzeugung feinster Strukturen im Nanobereich ermöglicht.

## Patentansprüche

1. Verfahren zum Ausfällen von Kupfer aus einer ein Kupfer-II-Salz, wie insbesondere Kupfer-II-Sulfat enthaltenden Lösung, **dadurch gekennzeichnet, dass** die Lösung mittels grünem Licht belichtet wird.

2. Verfahren nach Anspruch 1, **dadurch gekennzeichnet, dass** die Lösung zunächst erhalten wird durch Mischen von Kupferoxid mit Schwefelsäure oder mit Natriumpersulfatlösung und anschliessender Neutralisierung mittels einer basischen Lösung enthaltend einen Photolack bzw. eine sogenannte Photoresistlösung.

3. Verfahren nach einem der Ansprüche 1 oder 2, **dadurch gekennzeichnet, dass** die Lösung mittels eines Lasers belichtet wird, aufweisend dieselbe Wellenlänge, welche der Farbe der Kupfer-II-Salzlösung, wie beispielsweise der Kupfer-II-Sulfatlösung bzw. Kupfervitriol entspricht.

4. Verfahren zum Erzeugen von Leiterbahnen bzw. einer Leiterstruktur auf einem flächigen Substrat, wie einer Leiterplatte, einem Chip oder dergleichen, **dadurch gekennzeichnet, dass** das Substrat mittels einer Lösung enthaltend u.a. ein Kupfer-II-Salz, wie Kupfer-II-Sulfat überdeckt wird, welche Lösung mittels grünem Licht belichtet wird, entsprechend der zu erzeugenden Leiterbahn bzw. -struktur.

5. Verfahren nach Anspruch 4, **dadurch gekennzeichnet, dass** die Kupfer-II-Salzlösung, wie insbesondere die Kupfer-II-Sulfatlösung, wie Kupfervitriollösung, erhalten wird durch Mischen von zunächst Kupferoxid mit Natriumpersulfat oder durch Lösen von einer auf dem Substrat angeordneten Kupferschicht mittels Natriumpersulfat und anschliessender Neutralisation mittels einer basischen, wässrigen Lösung enthaltend einen Photolack.

6. Verfahren nach Anspruch 5, **dadurch gekennzeichnet, dass** eine weitgehendst gesättigte Kupfervitriollösung erzeugt wird und für das anschliessende Neutralisieren auf einem pH-Wert von ca. 7 eine wässrige Lösung von Ätznatron mit einem Photolack verwendet wird.

7. Verfahren nach einem der Ansprüche 4 bis 6, **dadurch gekennzeichnet, dass** zunächst die Kupfervitriol enthaltende Lösung auf das Substrat aufgetragen bzw. aufgespritzt wird und anschliessend die basische Lösung, enthaltend einen Photolack, worauf die Belichtung mittels eines Lasers im grünen Lichtbereich erfolgt, wobei die Wellenlänge des Laserlichts der Wellenlänge der Farbe von Kupfervitriol entspricht.

8. Verfahren nach einem der Ansprüche 4 bis 7, **dadurch gekennzeichnet, dass** die auf dem Substrat angeordnete Lösung nach Belichten mittels grünem Laserlicht mit einer anderen Farbe belichtet wird, wie im Falle eines Photolacks, enthaltend beispielsweise Silbernitrat mit einem blauen Laserlicht.

9. Verfahren nach einem der Ansprüche 4 bis 8, **dadurch gekennzeichnet, dass** diejenigen Bereiche der Substratoberfläche nicht belichtet werden, an welchen sogenannte Piezokristalle abzuscheiden sind, wie im Falle eines Siliziumwafers NaSiO₂ Dotierungen.

10. Verfahren nach einem der Ansprüche 4 bis 9, **dadurch gekennzeichnet, dass** nach Erzeugen der Kupferleiterbahnen und ggf. weiterer Beschichtungen, die Oberfläche mittels einer wässrigen alkoholischen Lösung gewaschen wird.

11. Verwendung des Verfahrens zum Herstellen von Chips, Leiterplatten, Mikroprozessoren, Schaltungen und dergleichen.
